# EUROPÄISCHE PATENTANMELDUNG

(11) **EP 2 065 716 A1**
(43) Veröffentlichungstag der Anmeldung: **03.06.2009**
(21) Anmeldenummer: 07023135.2
(22) Anmeldetag: 29.11.2007
(51) Int. Cl.: G01R 29/08, H01Q 21/00, G01S 3/74

(54) **EMV-Analyse Gerät**

(71) Anmelder: Lambda:4 GmbH & Co. KG, 22767 Hamburg (DE)
(72) Erfinder: Reimann, Rönne, 22769 Hamburg (DE)

(57) **Zusammenfassung**

Die Erfindung betrifft ein Verfahren zur Analyse eines Wellenfeldes bei dem eine aus Messwerten errechnete Autokorrelationsmatrix und eine aus Berechnung oder Kalibrationsmessungen gewonnene Arrayresponse verwendet werden, um durch Abstandsberechnung, insbesondere über Projektion, die Einfallsrichtung, die Polarisation, die Phase und/oder die Krümmung von einem oder mehreren Wellenfeldanteilen zu ermitteln, sowie eine Vorrichtung zur Analyse eines Wellenfeldes gemäß dem Oberbegriff des Anspruchs 9 und Verfahren zur Analyse eines Wellenfeldes und die Verwendung einer Arrayresponse zur Analyse eines Wellenfeldes beziehungsweise einer Autokorrelationsmatrix von Messwerten, zur Ermittlung von zumindest relativen Leistungsobergrenzen von Wellenfeldanteilen.

Durch die Verwendung einer erfindungsgemäßen mehrdimensionalen Arrayresponse beziehungsweise erfindungsgemäßen Leistungsobergrenzen auf Grund der Eigenwerte der Autokorrelationsmatrix von Messwerten, wird es ermöglicht, Rechenzeit und Speicherplatz zu sparen und dadurch auf kleinerem Raum bessere Analysen von Wellenfeldern zu berechnen.

## Beschreibung

Die Erfindung betrifft ein Verfahren zur Analyse eines Wellenfeldes gemäß dem Oberbegriff des Anspruchs 1, sowie eine Vorrichtung zur Analyse eines Wellenfeldes gemäß dem Oberbegriff des Anspruchs 9 und Verfahren zur Analyse eines Wellenfeldes und die Verwendung einer Arrayresponse zur Analyse eines Wellenfeldes beziehungsweise einer Autokorrelationsmatrix von Messwerten, zur Ermittlung von zumindest relativen Leistungsobergrenzen von Wellenfeldanteilen.

Es ist bekannt, Wellenfelder durch verschiedene Anordnungen von Empfangsvorrichtungen zu analysieren. Beispielsweise werden drehende Anordnungen von Empfangsvorrichtungen zur Bestimmung der Einfallsrichtung verwendet. Auch ist es bekannt, die Signale von mehreren statisch angeordneten Empfangsvorrichtungen auszuwerten.

Insbesondere ist es bekannt, dazu eine Arrayresponse der verwendeten Empfangsvorrichtungsanordnung zu verwenden. Eine Arrayresponse gibt an, welches Signal der Empfangsvorrichtungsanordnung zu entnehmen ist, wenn eine bestimmte Strahlung auf die Empfangsvorrichtungsanordnung einwirkt. Dementsprechend kann eine Arrayresponse berechnet oder durch Kalibration gewonnen werden. Eine vorbekannte Arrayresponse ist entweder eine Funktion oder besteht aus einer Menge von Vektoren. Eine Arrayresponse als Funktion ist eine Zuordnung zwischen den Eigenschaften einer einfallenden Welle (Frequenz (f), Phase, Einfallsrichtung (alpha, phi), Polarisation, Wellenfrontkrümmung, Feldstärke)) und den von den einzelnen Empfangsvorrichtungen gelieferten Signalen. Als Summe von Vektoren besteht die Arrayresponse aus einer Menge von Arrayresponsekomponenten, die jeweils Vektoren der von den einzelnen Empfangsvorrichtungen gelieferten Signale sind und einer bestimmten Kombination von Ausprägungen der möglichen Eigenschaften einer einfallenden Welle zugeordnet sind. Dabei sind die Arrayresponsen unterschiedlich differenzierend, beinhalten als Variablen unterschiedliche Mengen von Eigenschaften von Wellen. Beispielsweise können Polarisation und Phase vernachlässigt oder bei bestimmten Anwendungen nicht erforderlich sein, und stattdessen insbesondere die Einfallsrichtung von Interesse sein. Wenn dazu auf Grund der Gegebenheiten die Berücksichtigung der Parameter f, phi und alpha ausreicht, dann könnte eine Arrayresponse eine vektorielle Funktion der Form A(alpha, phi, f) sein. Wenn dabei die Arrayresponse aus einzelnen Vektoren besteht, könnte sie aus der Menge der Vektoren A_{alpha(k),phi(i),f(n)} bestehen. Wobei k, I, n natürliche Indizes sind und verschiedene Winkel im Bereich von für alpha [0;360[ und für phi[0;180[ und Frequenzen f indizieren. Arbeitet man beispielsweise mit Frequenzen im Bereich von 1 bis 10 Herz und will man den gesamten Raum abdecken und eine Auflösung von delta f = 1 Herz und delta phi = delta alpha = 6° erreichen, besteht die Arrayresponse aus 10 x 60 x 30 = 18 000 Vektoren. Diese Vektoren sind Vektoren der Messwerte, also komplexer Zahlen (Amplitude und Phase), und besitzen die Dimension a, wobei a die Anzahl der Empfangsvorrichtungen ist. Des Weiteren ist es bekannt, aus den die komplexen Messwerte der a Empfangsvorrichtungen (Amplitude und Phase) enthaltenden Messwertvektoren mᵢ verschiedener Messungen i, wobei die Messungen Messungen unkorrelierter Signale oder dekorrelierte Messungen (z.B. durch Messungen auf unterschieldichen Frequenzen) sind, die Matrix M zu bilden, deren i Spalten die mᵢ Messwertvektoren bilden. Aus dieser Matrix M wird denn die Autokorrelationsmatrix AKM = E(MM^{H}) berechnet, wobei M^{H} die komplex konjugierte Transponierte von M ist und E(M) die normierte von M ist. Aus dieser AKM können Eigenvektoren EV und Eigenwerte EW berechnet werden. An Hand der Eigenwerte ist es bekannt, zu versuchen Rauschen von Signal zu trennen. Auch weitere Analysen der AKM, beispielsweise auf Basis ihrer Inversen sind bekannt. Die Ergebnisse werden dann in Bezug zur Arrayresponse gesetzt, meist durch Projektion, um so auf die (wahrscheinlichen, näherungsweisen) Eigenschaften des an der Empfangsvorrichtungsanordnung vorliegenden Wellenfeldes zu schließen. Beispielsweise werden die nach Abtrennung des Rauschanteils auf Basis der Eigenwerte verbleibenden Signalanteile (Unterraum) mit der Arrayresponse projiziert.

Den vorbekannten Verfahren ist gemein, dass sie, um große Genauigkeit zu erzielen viel Speicherplatz und/oder Rechenzeit benötigen beziehungsweise auf ausgedehnte Empfangsvorrichtungsanordnungen angewiesen sind. Insbesondere treten dann Probleme auf, wenn die Vorrichtung räumlich klein gestaltet, insbesondere als ein handliches, kompaktes Gerät realisiert werden und mit elektromagnetischen Wellen mit Wellenlängen im mm bis cm Bereich gearbeitet werden soll, und/oder die Umgebung inhomogen gestaltet ist. Denn dann tritt auf Grund der im Verhältnis zur Wellenlänge nicht mehr großen räumlichen Ausdehnung der Empfangsvorrichtungsanordnung eine erhebliche Verschlechterung der Auflösung ein. Des Weiteren werden solche, kompakten Geräte anfällig für Einflüsse aus der Umgebung, wie beispielsweise den Bediener und/oder das Gehäuse selbst. Werden beispielsweise mehrere (insbesondere auch in Bezug auf die Polarisation) gleiche Empfangsvorrichtungen (a) angeordnet, sind ihre Ausgangssignale (Sₐ) in Abhängigkeit von der Polarisation (P) der eingestrahlten Welle unterschiedlich, also Sₐ₌₁(P) != Sₐ₌₂(P). Daher ist es notwendig, dass die Arrayresponse in diesen Fällen die Polarisation als Parameter beinhaltet. Solche Probleme treten bei (im Vergleich zur Wellelänge) sehr ausgedehnten Empfangsvorrichtungsanordnungen in homogener Umgebung kaum auf. Somit ist es Aufgabe der vorliegenden Anmeldung, bei möglichst geringem Rechenaufwand und Speicherbedarf und bei Verwendung von Platz sparenden Empfangsvorrichtungsanordnungen eine möglichst genaue Analyse eines Wellenfeldes zu ermöglichen.

Dies wird erreicht durch ein Verfahren nach Anspruch 1, einer Vorrichtung nach Anspruch 9, sowie Verwendungen nach den Ansprüchen 11 bis 13. Die abhängigen Ansprüche 2 bis 8 und 10 geben bevorzugte Weiterbildungen an.

Gemäß Anspruch 1 wird zur Analyse eines Wellenfeldes, insbesondere eines elektromagnetischen Wellenfeldes, eine aus Messwerten errechnete Autokorrelationsmatrix und eine aus Berechnung oder Kalibrationsmessungen gewonnene Arrayresponse verwendet. Dabei wird durch Abstandsberechnung, insbesondere über Projektion, die Einfallsrichtung, die Polarisation, die Phase und/oder die Krümmung von einem oder mehreren Wellenfeldanteilen ermittelt, indem die Arrayresponse so gewählt wird, dass sie N-dimensionale Räume bildet, wobei N >= 2 ist, und/oder indem aus Messwerten, insbesondere aus deren Verhältnissen, von errechneten Eigenwerten zumindest relative Leistungsobergrenzen von Wellenfeldanteilen ermittelt werden.

Dies bedeutet, dass statt der Arrayresponse als vektorielle Funktion oder als Menge von Vektoren eine Menge von Matrizen oder eine Matrixfunktion zur Anwendung gelangt und dementsprechend auch der vorbekannte Messwertvektor hier kein Vektor, sondern ein im Sprachgebrauch dieser Erfindung mehrdimensionales Objekt ist. Im zweidimensionalen Fall, bei dem Arrayresponsebenen zur Anwendung gelangen, die Beispielsweise durch die Polarisation, dargestellt durch die Winkel p1 und p2, Räume, die im zweidimensionalen Falls Ebenen sind, aufspannen, kann dies so dargestellt werden: Die Arrayresponse ist dann eine Menge von Matrizen, beispielsweise die Menge A_{alpha(k),phi(l),f(n),} wobei k, l, n natürliche Zahlen sind und die verschieden Winkel alpha [0;360[ und phi[0;180[ und Frequenzen f indizieren. Dabei ist jedes A_{alpha(k),phi(l),f(n)} jedoch eine Matrix von 2 x a komplexen Zahlen, wobei die komplexen Zahlen die Amplitude und die Phase der Messwerte für die einzelnen alpha(k),phi(I),f(n), zwei orthogonale Polarisationsrichtungen und die a Empfangsvorrichtungen angeben.

Durch die Verwendung einer Arrayresponse, die mehrdimensionale Räume aufspannt, im folgenden mehrdimensionale Arrayresponse, ist es möglich, bei Einsparung von Rechenzeit und Speicherbedarf auf kleine Empfangsvorrichtungsanordnungen zurück zugreifen und trotzdem hervorragende Analysen des Wellenfeldes, beispielsweise von Welleneinfallsrichtungen, zu erreichen. Dies ist möglich, da die Projektion mehrdimensionaler Objekte im Vergleich zur Einsparung in Bezug auf die Anzahl der nötigen Berechnungen, nur unwesentlich aufwendiger ist, als die Projektion eindimensionaler Objekte und dadurch die Auswertung von mehr Parametern mit höherer Auflösung möglich ist. Solche eindimensionalen Objekte sind die vorbekannte Arrayresponsen, nämlich einzelne (komplexe) Vektoren, die immer genau in einer Richtung zeigen. Erfindungsgemäße mehrdimensionale Arrayresponsen hingegen bilden zumindest Ebenen und zeigen somit nicht in eine Richtung. Dazu kommt die Speicherplatz Ersparnis. Zurückkommend auf das eingangs erwähnte Beispiel, bei dem die Arrayresponse aus 10 x 60 x 30 = 18 000 komplexen Vektoren der Dimension a besteht, berechnet sich der Speicherbedarf bei 10 Empfangsvorrichtungen (a = 10), wenn man die Polarisation mit der gleichen Winkelgenauigkeit auflösen will (6°), und bei Verwendung von 16byte pro komplexem Wert zu mindestens 18 000 x 10 x 60 x 30 x 16byte = 4,83 GB. Bei Verwendung einer erfindungsgemäßen Arrayresponse reduziert sich der Speicherbedarf, wie sich umgehend erschließt, auf 18 000 x 10 x 2 x 16byte = 0,1 GB. Es ist klar, dass dieser Vorteil umso größer ist, je höher die Dimension der mehrdimensionalen Arrayresponse und je genauer die Auflösung gewählt werden.

Auch die Ersparnis in Bezug auf die Rechenleistung erschließt sich umgehend. Statt mindestens 18 000 x 60 x 30 = 32 400 000 Vektoren mit der jeweiligen AKM der Messwerte projizieren zu müssen, reicht es erfindungsgemäß aus, 18 000 x 2 = 36 000 zweidimensionale Arrayresponsekomponenten mit dem aktuellen Messwertobjekt zu projizieren. Geschätzt ist der Rechenaufwand bei einer solchen Projektion zweidimensionaler Objekte um etwa den Faktor 4 höher als bei eindimensionalen, pro weitere Dimension erhöht er sich weiter schätzungsweise etwa um den Faktor 2. Damit ergibt sich im vorliegenden Beispiel eine mögliche Reduktion der Rechenleistung um etwa den Faktor 225.

Es ist sofort ersichtlich, dass dieser Faktor, ebenso wie die Speicherplatzersparnis umso größer wird, je höher die Auflösung und die Anzahl der berücksichtigten Parameter (wie Frequenz, Phase, Polarisation, Krümmung etc.) sind.

Die nötige Anzahl und Auswahl der Parameter wird durch die Ausdehnung der Empfangsvorrichtungsanordnung im Verhältnis zur Wellenlänge des zu analysierenden Wellenfeldes, die Umgebung und die Anforderung an die Auflösung und Genauigkeit bestimmt.

Um Eigenschaften des Wellenfeldes zuverlässig durch Projektion mehrdimensionaler Objekte bestimmen zu können, ist es jedoch erforderlich, dass sich das Problem näherungsweise linear verhält und so näherungsweise als entkoppelt betrachtet werden kann. Dies ist jedoch zumindest in eingeschränkten Bereichen in der Regel (näherungsweise) gegeben. So kann beispielsweise die Wellenfrontkrümmung entlang der Ausdehnung der Empfangsvorrichtungsanordnung näherungsweise bis etwa 10° als ausreichend linear angesehen werden. Für die Polarisation sind zumindest theoretische keine Einschränkungen zu machen.

Auch kann auf Grund der auf Basis der AKM berechneten Eigenwerte eine Berechnung von zumindest relativen Leistungsobergrenzen für Wellenfeldanteile erfolgen.

Aus den EW, insbesondere aus deren Verhältnissen, lassen sich die Verhältnisse der aus den Richtungen der zugehörigen Eigenvektoren eingestrahlten Leistungen bestimmen. Ist des Weiteren die gesamte eingestrahlte Leistung bekannt, können daraus absolute Leistungen errechnet werden. Bei dieser Leistungsanalyse geben die zugehörigen EW genau den Leistungsanteil der Wellenfeldkomponente mit Einfallsrichtung entlang dem EV in der Summe aller Wellenfeldkomponenten, also den jeweiligen Anteil an der Wellenfeldleistung, an.

Es ist einleuchtend, dass durch Linearkombinationen auch die Leistungen aus jeder beliebigen Einfallsrichtung ermittelt werden können. Dies kostet jedoch vergleichsweise viel Rechenzeit und kann zu Schwierigkeiten, insbesondere unzuverlässigen Ergebnissen, führen, wenn auf Grund von Messungenauigkeiten Umgebungseinflüssen und/oder nicht vollständiger Auswertung, zum Beispiel aus Gründen der Rechenzeiteinsparung, nicht alle Wellenfeldanteile bekannt sind.

Besonders vorteilhaft, da Rechenzeit sparend und auch in oben genannten Problemfällen anwendbar, ist es daher, erfindungsgemäß nicht die exakten (relativen oder absoluten) Leistungen eines Wellenfeldanteils zu berechnen, sondern lediglich Leistungsobergrenzen zu berechnen. Also Werte zu berechnen, die Obergrenzen für die (relativen oder absoluten) Leistungen einzelner Wellenfeldanteile angeben. Dadurch müssen nicht mehr alle Linearkombinationen durchgerechnet werden. Die dadurch in Kauf genommenen Ungenauigkeiten können durch dem Fachmann bekannte Berechnungsmethoden im Verhältnis zur eingesparten Rechenzeit gering gehalten werden und werden durch die gewonnene Zuverlässigkeit ohnehin aufgewogen.

Bevorzugt ermittelt man die am besten zu den EV passenden Komponenten der Arrayresponse beziehungsweise die Parameter, die die Arrayresponsfunktion den EV möglichst gleich machen, also beispielsweise die lokalen Minima der Projektion. Im Anschluss stellt man diese Komponenten der Arrayresponse als Linearkombinationen der EV da, zerlegt sie also nach der Basis der EV. Dann geben die in den Zeilen stehenden komplexen Zahlen (Linearkoeffizienten) die Anteile der EV an den Komponenten der Arrayresponse an. Insbesondere bei Normierung der AKM und der Arrayresponse der Art, dass die Summe der Quadrate der EW 1 beträgt, können folgendermaßen Leistungsobergrenzen einfach berechnet werden, Abwandlungen sind dem Fachmann möglich: Man bildet die Verhältnisse aus EW und dem Quadrat des zugehörigen Linearkoeffizienten. Für jede Arrayresponsekomponente erhält man dadurch einen Satz von Verhältnissen, die relative Obergrenzen für die Leistung des Wellenfeldanteils passend zu der Arrayresponsekomponente angeben. Da es sich um Obergrenzen handelt, muss verständlicherweise nur das kleinste Verhältnis betrachtet werden.

Ermittelt man diese relative Obergrenze für alle oben als am besten passend (beispielsweise durch Bestimmung der lokalen Minima der Projektionsfunktion) ermittelten Arrayresponsekomponenten und kennt man auch die insgesamt eingestrahlt Leistung, lassen sich aus den relativen Werten absolute Werte berechnen.

Dieses Vorgehen ist besonders vorteilhaft, da in der Praxis die Eigenwerte sehr stark abfallen, das heißt es gibt wenige im Verhältnis zu den anderen EW große EW. Dadurch kann einfach ermittelt werden, welche Wellenfeldanteile weiter betrachtet werden sollen. Bei dieser Entscheidung kann auch das Wissen um das Auflösungsvermögen der Empfangsvorrichtung eingehen. Durch ein solches Vorgehen lassen sich auch schnell Wellenfeldanteile identifizieren, die auf Grund von nur wenig möglicher Leistung (niedriger Leistungsobergrenze) für die weitere Auswertung weniger stark bewertet werden können.

Vorteilhaft ist dabei auch, dass die Leistungsobergrenzen bei der Abstandsberechnung schon fast mitberechnet werden und im Gegensatz zu vorbekannten Verfahren kaum weiterer Rechenaufwand nötig ist.

Im Gegensatz zu den vorbekannten Verfahren, die auf Grundlage der Eigenvektoren einen Unterraum ermitteln, der als Signal betrachtet wird, und den komplementären Unterraum bei der Ermittlung der Eigenschaften des Wellenfeldes im Folgenden außer Acht lassen, und somit nur eine gewissen Menge von Eigenvektoren und Eigenwerten wirklich berücksichtigen, werden erfindungsgemäß auch alle Eigenwerte verwendet, um eine (relative), bevorzugt durch Obergrenzen genäherte, Verteilung der einfallenden Energie auf einzelne Einfallsrichtungen zu ermitteln. Dadurch wird es möglich, insbesondere die Einfallsrichtungen einzelner Anteile des Wellenfeldes, mit besonderer Genauigkeit zu bestimmen. Dabei kann je nach Anwendung die räumliche Energieeinfallsverteilung errechnet werden und/oder eine beziehungsweise einzelne besonders ausgezeichnete Einfallsrichtungen ermittelt werden.

Dazu kann es sich anbieten, vor der Leistungsberechnung weitere Transformationen auf die AKM anzuwenden, um beispielsweise Rauschen zu unterdrücken.

Auf Grund der vorgehenden Ausführungen ist es dem Fachmann einleuchtend, dass das die Erfindung bei jeder Art von Wellen in allen Frequenzbereichen angewendet werden kann.

Besonders vorteilhaft ist es, gemäß Anspruch 2 die Abstandsberechnung durch Projektion von Autokorrelationsmatrix und Arrayresponse durchzuführen. Dadurch können auf einfache Weise Abstände gewonnen werden. Aus ihnen können dann Eigenschaften des Wellenfeldes bestimmt werden, indem die zu den Messwerten näherungsweise passende Linearkombination (unter anderem Rauschen verhindert eine exakte Übereinstimmung) der Arrayresponsekomponenten herangezogen wird, um eine entsprechende Linearkombination der den einzelnen Arrayresponsekomponenten zugeordneten Wellenfeldeigenschaften zu bilden.

Besonders Rechenzeit sparend ist es, die Arrayresponse nach Anspruch 3 in orthogonalisierter Form zu verwenden.

Vorzugsweise wird eine Arrayresponse verwendet, die durch die Polarisationsrichtungen, im Sprachgebrauch dieser Erfindung, 2-dimensionale Räume aufspannt. Dadurch können insbesondere in Bezug auf die Einfallsrichtung besonders gute Analyseergebnisse erzielt werden.

Je nach Anwendung wird bevorzugt eine Arrayresponse eingesetzt, die durch die Polarisationsrichtungen und die Frequenz oder durch die Polarisationsrichtung und die Frequenz oder durch die Polarisationsrichtungen und die Krümmung der Wellenfront 4-dimensionale Räume aufspannt.

Sollen noch mehr Eigenschaften des Wellenfelds bestimmt werden kann beispielsweise auch eine Arrayresponse angewandt werden, die durch die Polarisationsrichtungen, die Frequenz und die Krümmung der Wellenfront 8-dimensionale Räume aufspannt.

Bei der Wahl der Dimension der Arrayresponse ist jedoch auf ein ausgewogenes Verhältnis zwischen der Dimension, der Anzahl der zu einer Messwertmatrix zusammengefassten Messungen und der Anzahl der Empfangsvorrichtungen zu achten. Bei zu großer Anzahl der Dimensionen wird sonst die zufällige Trefferwahrscheinlichkeit, das zufällige Übereinstimmen von Messwertobjekten mit Arrayresponsekomponenten zu groß, um zuverlässige Analysen errechnen zu können.

Als geeignet haben sich beispielsweise die Verwendung von Frequenz, alpha, phi und der Polarisation als Parameter der Arrayresponse bei 20 bis 40, insbesondere 32, Antennen a und 5 bis 25, insbesondere 8 bis 16, Messungen i für eine Messwertmatrix erwiesen. Als besonders vorteilhaft hat sich dabei erwiesen, i<a zu wählen, denn dann existieren typischerweise alle i EW ungleich null und besitzt der Eigenvektorraum somit die Dimension i.

Um weiter Rechenleistung und oder Speicherplatz zu sparen, kann es besonders vorteilhaft sein, die Dimension der durch die Arrayresponse aufgespannten Räume durch mindestens eine Approximation zu reduzieren. Dazu werden bevorzugt die Eigenvektoren der AKM der Arrayresponse mit den kleinsten Eigenwerten weggelassen. Der Fehler der Approximation lässt sich dann aus der Summe der weggelassenen Eigenwerte berechnen. Besonders vorteilhaft ist es, auf Grund der Eigenwerte die zumindest relativen Leistungen der Wellenfeldfeldanteile mit Einfallrichtung parallel zu den Eigenvektoren zu ermitteln. Dies spart Rechenzeit, da die zu Ermittlung der Leistung aus anderen Einfallsrichtungen nötigen Berechnungen von Linearkombinationen der Eigenvektoren entfallen können.

Die Aufgabe wird ebenfalls durch eine Vorrichtung mit mindestens zwei Empfangsvorrichtungen und einer gespeicherten Arrayresponse der Empfangsvorrichtungen oder mit Mitteln zu deren Berechnung und Mitteln zur Berechnung der Autokorrelationsmatrix der Messwerte der Empfangsvorrichtungen und Mitteln zur Abstandsberechnung, insbesondere über Projektion, gelöst, bei der die Arrayresponse N-dimensionale Räume bildet, wobei N >= 2 ist, und/oder bei der Mittel vorgesehen sind, um aus aus der Autokorrelationsmatrix der Messwerte gewonnen Eigenwerten, insbesondere aus deren Verhältnissen, zumindest relative Leistungsobergrenzen von Wellenfeldanteilen zu ermitteln.

Besonders vorteilhaft ist, wenn die Mittel zur Abstandsberechnung so ausgebildet sind, dass sie die Abstandsberechnung durch Projektion von Autokorrelationsmatrix und Arrayresponse durchführen.

Die Aufgabe wird auch gelöst durch die Verwendung einer Arrayresponse, um durch Abstandsberechnung, insbesondere über Projektion, insbesondere von der Autokorrelationsmatrix der Messwerte und der Arrayresponse, die Einfallsrichtung, die Polarisation, die Phase und/oder die Krümmung von einem oder mehreren Wellenfeldanteilen zu ermitteln, bei der die Arrayresponse N-dimensionale Räume bildet, wobei N >= 2 ist.

Ebenfalls zur Lösung der Aufgabe können auf Basis einer Autokorrelationsmatrix von Messwerten berechnete Eigenwerte, insbesondere deren Verhältnissen, zur Ermittlung von zumindest relativen Leistungsobergrenzen von Wellenfeldanteilen verwendet werden.

Zur Lösung der Aufgabe besonders bevorzug ist die Verwendung von auf Basis einer Autokorrelationsmatrix von Messwerten zumindest zweier Empfangsvorrichtungen berechneten Eigenwerten, insbesondere deren Verhältnissen, zusammen mit Projektionen der Autokorrelationsmatrix und

Arrayresponse der Empfangsvorrichtungen zur Ermittlung von zumindest relativen Leistungsobergrenzen von Wellenfeldanteilen. Durch solche erfindungsgemäße Verwendung beziehungsweise Lösungen können gegenüber vorbekannten Lösungen deutliche Vorteile in Bezug auf die Genauigkeit der Analyse, der Einsparung von Rechenleistung und Speicherplatz und den Platzerfordernissen der benötigten Empfangsvorrichtungsanordnungen realisiert werden. Dabei ist dem Fachmann sofort klar, dass durch die Einsparung von Rechenleistung und Speicherplatz bei gleicher Ausstattung höhere Genauigkeiten erzielt werden können beziehungsweise umgekehrt bei gegebener Genauigkeit Rechenleistung und Speicherplatz eingespart werden können. Gleiches gilt für den Platzbedarf der Empfangsvorrichtungsanordnung. Denn durch größere Empfangsvorrichtungsanordnung können im Allgemeinen bei ansonsten gleichen Umständen höhere Genauigkeiten erzielt werden.

Eine besondere Einsparung von für die Empfangsvorrichtungsanordnung benötigtem Platz kann durch diese Erfindung aber dadurch erreicht werden, dass nicht nur eine Arrayresponse größerer Genauigkeit verwendet wird, sondern auch die Vielzahl der durch Empfangsvorrichtungen gelieferten Informationen besser ausgewertet werden können. Denn bei gleicher Rechleistung können deutlich mehr Parameter (Frequenz, Krümmung etc.) abgeglichen werden, als das mit Vorbekanntem möglich ist.

Die vorgehende Beschreibung der Erfindung hat deutlich gemacht, wie die Aufgabe zu lösen ist und welche Vorteile sich daraus unter anderem ergeben. Die genaue Ausgestaltung erschließt sich, wie auch Abwandlungen, die nicht vom Kern der Erfindung weg führen, dem Fachmann auf Grund seines Wissens.

Nachfolgend soll nun anhand der Figur eine beispielhafte Ausführung beschrieben werden, auf die die Erfindung jedoch nicht beschränkt ist. Das Beispiel soll vielmehr einen möglichen Weg zur Umsetzung der Erfindung beschreiben.
Dabei zeigt:
Fig.1
einen schematischen Aufbau einer erfindungsgemäßen Vorrichtung.

Die Zeichnung stellt lediglich eine schematische Abbildung da. Die genauere Ausgestaltung erschließt sich dem Fachmann, wie auch Abwandlungen. Die Erfindung ist insbesondere nicht auf die Figur oder das Ausführungsbeispiel beschränkt.

Die Empfangsvorrichtungen 1 bilden die Empfangsvorrichtungsanordnung. In diesem Ausführungsbeispiel sind die Empfangsvorrichtungen 1 a Antennen für elektromagnetische Strahlung, bevorzugt a=32. Aber auch jede andere Anzahl größer eins ist denkbar. Die Antennen weisen unterschiedliche Polarisationsrichtungen und Abstrahlcharakteristika auf. Die Signale der Antennen werden digitalisiert (hier nicht gezeigt) und in ein Messwertobjekt M, bestehend aus jeweils i Messungen der a Antennen, zusammengefasst (nicht summiert), wobei i bevorzugt zwischen 8 und 16 liegt, aber auch jede Anzahl in einem deutlich größeren Bereich möglich ist. In diesem Ausführungsbeispiel sind dabei je eine komplexe Zahl (Messwert) mit Informationen über Amplitude und Phase für jede der i Messungen und jede der a Antennen enthalten. Es liegen also im Sprachgebrauch dieser Schrift komplexe Messwertobjekte, effektiv also pro Zeiteinheit jeweils eine komplexe Matrix der Größe a x i vor. Diese Messwertmatrix wird in der ersten Berechnungseinheit 2 mit sich selbst korreliert. Dadurch wird die AKM erzeugt.

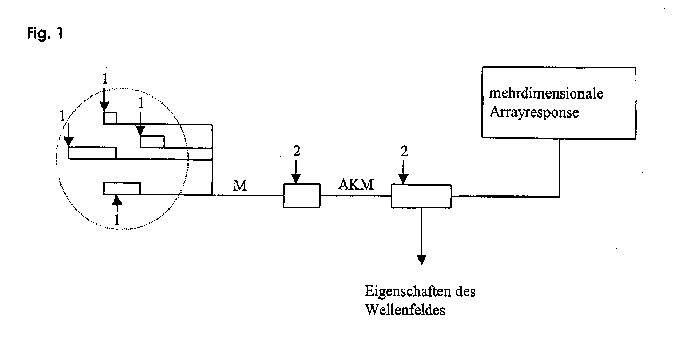

Im Speicher (in Fig. 1 rechts) befindet sich die hier, im Sprachgebrauch der Anmeldung, zweidimensionale komplexe Arrayresponse, die abgerufen wird und deren Komponenten mit der AKM der Messwerte in der zweiten Berechungseinheit 2 projiziert werden. Dadurch wird jeweils ein Abstand gewonnen. Daraus werden, ebenfalls in der zweiten Berechnungseinheit 2, die Eigenschaften des Wellenfeldes ermittelt, das sich näherungsweise aus einer Linearkombination der einzelnen Arrayresponsekomponenten zusammensetzt. Da die einzelnen den Arrayresponsekomponenten zugeordneten Wellenfeldanteile bekannt sind, kann aus deren Linearkombinationen das jeweils aktuell vorliegende Wellenfeld näherungsweise bestimmt werden. Probleme treten verständlicherweise dann auf, wenn nichtlineare Effekte merklich die Eigenschaften des Wellenfeldes prägen, da dann die einzelnen Wellenfeldanteile nicht mehr durch lineare Zerlegung des Wellenfeldes errechnet werden können. Jedoch sind solche nichtlinearen Effekte in den meisten Anwendungsbereichen vernachlässig- oder beherrschbar.

Somit kann in der Regel das Wellenfeld mit äußerster Genauigkeit analysiert werden und somit beispielsweise die Belastung durch elektromagnetische Strahlung differenziert beurteilt oder Quellen analysiert beziehungsweise aufgespürt und/oder voneinander getrennt werden.

### Bezugszelchenliste:

- 1: Empfangsvorrichtung
- 2: Berechnungseinheit

## Patentansprüche

1. Verfahren zur Analyse eines Wellenfeldes, insbesondere eines elektromagnetischen Wellenfeldes, bei dem eine aus Messwerten errechnete Autokorrelationsmatrix und eine aus Berechnung oder Kalibrationsmessungen gewonnene Arrayresponse verwendet werden, um durch Abstandsberechnung, insbesondere über Projektion, die Einfallsrichtung, die Polarisation, die Phase und/oder die Krümmung von einem oder mehreren Wellenfeldanteilen zu ermitteln, **dadurch gekennzeichnet, dass** die Arrayresponse N-dimensionale Räume bildet, wobei N >= 2 ist, und/oder dass aus aus Messwerten errechneten Eigenwerten, insbesondere aus deren Verhältnissen, insbesondere durch Divison durch das Quadrat je eines Linearkoeffizienten, zumindest relative Leistungsobergrenzen von Wellenfeldanteilen ermittelt werden.

2. Verfahren nach Anspruch 1 **dadurch gekennzeichnet, dass** die Abstandsberechnung durch Projektion von Autokorrelationsmatrix und Arrayresponse erfolgt.

3. Verfahren nach einem der vorhergehenden Ansprüche **dadurch gekennzeichnet, dass** die Arrayresponse orthogonalisiert ist.

4. Verfahren nach einem der vorhergehenden Ansprüche, **dadurch gekennzeichnet, dass** die Arrayresponse durch die Polarisationsrichtungen 2-dimensionale Räume aufspannt.

5. Verfahren nach einem der vorhergehenden Ansprüche, **dadurch gekennzeichnet, dass** die Arrayresponse durch die Polarisationsrichtungen und die Frequenz oder durch die Polarisationsrichtungen und die Krümmung der Wellenfront 4-dimensionale Räume aufspannt.

6. Verfahren nach einem der vorhergehenden Ansprüche, **dadurch gekennzeichnet, dass** die Arrayresponse durch die Polarisationsrichtungen, die Frequenz und die Krümmung der Wellenfront 8-dimensionale Räume aufspannt.

7. Verfahren nach einem der Ansprüche 2 bis 6, **dadurch gekennzeichnet, dass** die Dimension der durch die Arrayresponse aufgespannten Räume durch mindestens eine Approximation reduziert ist.

8. Verfahren nach einem der vorhergehenden Ansprüche, **dadurch gekennzeichnet, dass** auf Grund der Eigenwerte zumindest relative Leistungsobergrenzen der Wellenfeldfeldanteile mit Einfallrichtung parallel zu den Eigenvektoren ermittelt werden.

9. Vorrichtung zur Analyse eines Wellenfeldes, insbesondere eines elektromagnetischen Wellenfeldes, beinhaltend mindestens zwei Empfangsvorrichtungen (1) und eine gespeicherte Arrayresponse der Empfangsvorrichtungen (1) oder Mittel zu deren Berechnung und Mittel zur Berechnung der Autokorrelationsmatrix der Messwerte der Empfangsvorrichtungen (1) und Mittel zur Abstandsberechnung, insbesondere über Projektion, zur Ermittlung der Einfallsrichtung, der Polarisation, der Phase und/oder der Krümmung von einem oder mehreren Wellenfeldanteilen, **dadurch gekennzeichnet, dass** die Arrayresponse N-dimensionale Räume bildet, wobei N >= 2 ist, und/oder dass Mittel vorgesehen sind, um aus der Autokorrelationsmatrix der Messwerte gewonnen Eigenwerten, insbesondere aus deren Verhältnissen, insbesondere durch Divison durch das Quadrat je eines Linearkoeffizienten, zumindest relative Leistungsobergrenzen von Wellenfeldanteilen zu ermitteln.

10. Vorrichtung nach Anspruch 9, **dadurch gekennzeichnet, dass** die Mittel zur Abstandsberechnung die Abstandsberechnung durch Projektion von Autokorrelationsmatrix und Arrayresponse durchführen.

11. Verwendung einer Arrayresponse, um durch Abstandsberechnung, insbesondere über Projektion, insbesondere von der Autokorrelationsmatrix der Messwerte und der Arrayresponse, die Einfallsrichtung, die Polarisation, die Phase und/oder die Krümmung von einem oder mehreren Wellenfeldanteilen zu ermitteln, **dadurch gekennzeichnet, dass** die Arrayresponse N-dimensionale Räume bildet, wobei N >= 2 ist.

12. Verwendung von auf Basis einer Autokorrelationsmatrix von Messwerten berechneten Eigenwerten, insbesondere deren Verhältnissen, insbesondere durch Divison durch das Quadrat je eines Linearkoeffizienten, zur Ermittlung von zumindest relativen Leistungsobergrenzen von Wellenfeldanteilen.

13. Verwendung von auf Basis einer Autokorrelationsmatrix von Messwerten zumindest zweier Empfangsvorrichtungen (1) berechneten Eigenwerten, insbesondere deren Verhältnissen, insbesondere durch Divison durch das Quadrat je eines Linearkoeffizienten, zusammen mit Projektionen der Autokorrelationsmatrix und Arrayresponse der Empfangsvorrichtungen (1) zur Ermittlung von zumindest relativen Leistungsobergrenzen von Wellenfeldanteilen.
